Europäisches Patentamt

European Patent Office

Office européen des brevets

(11) Publication number: **0 190 412**
**B1**

(12) **EUROPEAN PATENT SPECIFICATION**

(45) Date of publication of patent specification: **31.10.90**

(51) Int. Cl.⁵: **H 01 L 27/06, H 01 Q 1/38, H 01 Q 3/26**

(21) Application number: **85114296.8**

(22) Date of filing: **05.09.81**

(60) Publication number of the earlier application in accordance with Art. 76 EPC: **0 055 324**

(54) **Method for fabricating a planar phase-shifter.**

(30) Priority: **17.11.80 US 207289**

(43) Date of publication of application:
**13.08.86 Bulletin 86/33**

(45) Publication of the grant of the patent:
**31.10.90 Bulletin 90/44**

(84) Designated Contracting States:
**AT BE CH DE FR GB IT LI LU NL SE**

(56) References cited:
**DE-A-2 748 103**
**DE-B-2 047 814**
**US-A-3 475 700**
**US-A-3 811 128**
**US-A-4 033 788**
**US-E- 29 911**

**IEEE JOURNAL OF SOLID-STATE CIRCUITS,vol SC 13,No.4,August 1978, New York. EDEN et al. "Planar Ga As IC Technology:Application for digital LSI"Pages 419-425**

(73) Proprietor: **BALL CORPORATION**
**345 South High Street**
**Muncie Indiana 47302 (US)**

(72) Inventor: **Stockton, Ronald J.**
**Bonanza Star Route**
**Nederland Colorado 80466 (US)**
Inventor: **Munson, Robert E.**
**4040 Pinon Drive**
**Boulder Colorado 80302 (US)**

(74) Representative: **UEXKÜLL & STOLBERG**
**Patentanwälte**
**Beselerstrasse 4**
**D-2000 Hamburg 52 (DE)**

(56) References cited:
**IEEE TRANSACTIONS ON MICROWAVE THEORY AND TECHNIQUES,Vol.MTT-16, No.7 July,1968,New York. MEHAL, WACKER "Ga As integrated microwave circuits" pages 451-454**

Courier Press, Leamington Spa, England.

## Description

This invention relates generally to microwave circuits and to the fabrication thereof.

The state of the art in fabrication and construction of millimeter and sub-millimeter wave length microwave systems before the present invention was essentially a "bolt together" waveguide component technology. Individual circuits or discrete components were developed and then interconnected to provide the desired system. In essence, the "blocks" of the overall block diagram of the microwave system were assembled after each "block" was individually developed.

Various problems and shortcomings are inherent in the "bolt-together" approach. One such shortcoming is the high frequency limitation that exists when separate components are bolted together. The size and separation of individual components cannot be scaled proportionally for extremely short wave lengths, resulting in uncontrollable parasitic reactances which limit performance. Other difficulties inherent in the waveguide approach are bulkiness, excessive weight, and high manufacturing costs. In addition, minor design changes can result in costly hardware modifications.

The technology of electronic circuitry has evolved from discrete components such as diodes, transistors, capacitors, and resistors on printed circuit boards to the use of monolithic linear and digital integrated circuits. This trend has continued by combining specific integrated circuit functions into larger integrated circuits having versatile and multi-function capability such as in the case of electronic calculators, watches, and micro-computers.

Concurrently with these developments in electronic circuitry, similar techniques have been employed in the technology of microwave circuits. GaAs field effect transistors (FETs) have been developed as well as microwave integrated circuit components such as oscillators, mixers, amplifiers, detectors, and filters, using both monolithic and hybrid construction techniques. With the development of the micro-strip radiator, high performance monolithic micro-strip phased arrays have also been developed.

It has been recognized that there are advantages in performance and versatility to be gained by building micro-computer controlled antenna systems. Various multi-mode systems have been developed to demonstrate these advantages. In such systems, the electronics, comprising of integrated circuits mounted on printed circuit boards were packaged separately and interfaced with an antenna by means of a multi-conductor cable. Such construction represents the present state of the art in microwave system fabrication. To date, complete microwave systems have not been fabricated as a monolithic unit.

## Summary of the Invention

Realizing the inherent disadvantages and shortcomings of the previously utilized "bolt together" technology for the fabrication of millimeter and sub-millimeter wave length microwave systems, it is the primary objective of the present invention to provide a fabrication process for monolithic microwave integrated antennas suitable for high volume, low cost production that is also repeatable and reliable.

The method of fabrication described herein enable the physical integration of active microwave and digital circuits into a common substrate. The fabrication technique provided by this invention is not unique to a particular microwave system design but rather is applicable to a wide range of systems and systems frequencies, i.e., 10 GHz through $10^8$ GHz (ultraviolet). The fabrication technique set forth herein is based upon thin-film techniques. The fabrication of all components whether active or passive and their interconnections are formed by either semiconductor or thin-film processing steps.

Using the fabrication technique set forth herein, design changes can be implemented through mask and/or material and process variations rather than through the previously required intricate hardware modifications.

The monolithic nature of the microwave system has the inherent benefits of low volume (non-bulky), light weight, and high reliability. The fabrication process lends itself to automated, high volume production so that even the most complex designs will be repeatable and cost effective when compared with present fabrication and assembly techniques. The inherent accuracy and precision of the process enables component size and separation to be scaled with frequency thereby eliminating or reducing parasitic reactances for improved performance. The inherent repeatability will eliminate the need for "tweaking" or circuit adjustment to meet performance specifications.

In essence, the fabrication techniques set forth herein represent a unique marriage of the arts of semiconductor and integrated circuit fabrication techniques, used at frequencies lower than microwave, with integrated monolithic electromagnetic system techniques.

The fabrication technique features the use of ion implantation directly into high quality semi-insulating GaAs to form the active layer for planar FET elements.

## Brief Description of the Drawing

The invention will now be described in further detail with reference to the accompanying drawing wherein:

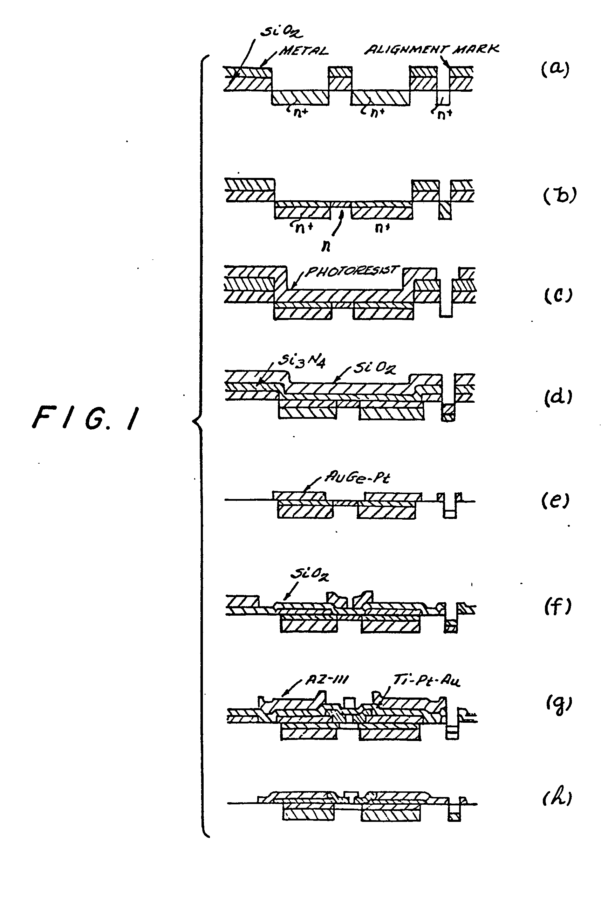

FIGURE 1 depicts the fabrication process for the planar GaAs FET phase shifter elements.

## Semiconductor Medium

The method of the invention provides a monolithic microwave integrated circuit as shown in FIGURE 1 fabricated on semi-insulating gallium arsenide (S. I. GaAs). However, other media, such as silicon and/or GaAs on sapphire represent potential alternatives. It is observed that at this time, only silicon and gallium arsenide present practical choices for X-band application because the processing technologies for these media are sufficiently mature so that consistent, repeatable results may be achieved at microwave frequencies. Other Groups III—V semiconductor compounds having better theoretical band gap and carrier mobility characteristics may ultimately be well suited for millimeter and sub-millimeter applications, but at the present time neither the material nor processing technology for these compounds has been sufficiently developed to provide the uniformity required for mass production. As a result the invention as set forth herein utilizes semi-insulating GaAs.

In further consideration of the semiconductor medium, PIN diodes fabricated in planar, mesa and beam-lead cnfigurations have been successfully used as switching elements at Y-band microwave frequencies and above for over a decade in "bolt together" systems. These devices are made from the highest quality bulk silicon with cutoff frequencies in excess of 2000 GHz. Silicon, however, has a maximum resistivity of only 200—300 ohm-cm undoped. The loss tangent of silicon is therefore many orders of magnitude worse than that of standard microwave substrate materials such as quartz, alumina and sapphire. Typical microstrip transmission lines on silicon have losses of several dB/cm. Thus, the dielectric losses in a microstrip radiator on bulk silicon would reduce aperture efficiency to 20%, which is impractical.

The use of a silicon on sapphire (SOS) medium would eliminate this loss problem by allowing the microwave radiator and feedline to be fabricated on the sapphire dielectric leaving silicon only in small areas where PIN diodes need to be fabricted. This would solve one problem but create another. To date the achievable electron mobility, $\mu n$, in SIS epitaxial layers is less than that of bulk silicon. Therefore, PIN diodes suitable for X-band switches are not practical.

Another negative aspect of silicon is that low noise amplifiers are impractical at X-band. This is significant because the ultimate benefits of monolithic microwave integrated circuits and antennas could not be realized in silicon at this frequency.

Microstrip radiators are fabricated as a metallization adjacent to the semiconductor material. Layers of Ti-Pt-Au are deposited sequentially on the semiconductor material. The final metallization layer of Au should be at least four (4) skin depths thick at the operating frequency to prevent excessive ohmic losses in the microwave conductors.

In conventional microstrip radiator designs such as illustrated by U.S. Patent 3,811,128 entitled "Electrical Scanned Microstrip Antenna" and U.S. Patent 3,921,177 entitled "Microstrip Antenna Structures and Array", the choice of a dielectric or substrate material is based on tradeoffs involving physcial size and efficiency. As an example conventional hybrid microwave integrated circuits are often configured on high dielectric constant substrates with small conductors in order to minimize physical size. Circuit losses in the "bolt together" systems are often not critical since amplification stages can be liberally incorporated. Conversely microstrip antennas, phasing networks and corporate feed networks are typical restricted to utilizing low dielectric constant materials such as teflon-fiberglass and employ larger conductors to achieve minimum loss, hence maximum gain.

In a monolithic microwave integrated circuit, however, these traditional tradeoffs are overshadowed by totally different requirements imposed by the semiconductor device. Since the performance of a semiconductor component is uniquely related to the physical properties of the material, radiators are adapted to the semiconductor medium without comprising element performance, i.e., radiation efficiency.

This adaptation is important because high efficiency, typically 90—95%, is an inherent "no-cost" characteristic of microstrip radiators. If this efficiency is inadvertently sacrificed, an amplifying component with its attendant increase in dc power will be required to recover the lost aperture gain. Such a trade-off is not at all attractive and therefore has been avoided.

Alternative microstrip radiators using quartz, alumina and sapphire substrates were tested as alternatives for the fabrication of radiators. Optimum performance was obtained for sapphire elements.

In essence, a microstrip element is a two slot radiator and the dielectric under the patch can be treated as a low impedance transmission line $\lambda/2$ long connecting the slots. The half-wavelength property of this transmission line is determined by the dielectric constant of the material, however, the radiated field is a function of the slot separation in terms of free-space wavelength. A typical element on Teflon (RTM)-fiberglass dielectric, $\varepsilon_r = 2,2$ has a half power beamwidth of 90°. A comparable element on sapphire has an $\varepsilon_r = 9,39$. The resonant dimension or slot separation is reduced due to the higher dielectric constant resulting in a smaller aperture, hence broader beamwidth. It is also significant to note that the aperture efficiency of the same sapphire element determined by integration of the far-field radiation patterns is in excess of 93%.

The sapphire element has a 2:1 VSWR bandwidth of 9,5% which is substantially greater than the typical 1—3% bandwidths associated with designs on lower dielectric materials.

Similar performance is obtained on slightly higher dielectric constant materials such as the semi-insulating (S.I.) GaAs with $\varepsilon_r = 12,6$ utilized in the present invention. Efficiency is slightly degraded since the loss tangent of S.I. GaAs having a resistivity of $10^8$ ohm-cm is equivalent to that of 99.6% $AL_2O_3$ or Alumina. The loss tangents for sapphire (mono-crystalline $AL_2O_3$) and S.I. GaAs or Alumina are $2 \times 10^{-5}$ and $1 \times 10^{-4}$ respectively. Although these values are nearly an order of magnitude apart, the additional loss due to increased dielectric dissipation is negligible since the term is only 1,5% of the conductor loss. The net result, then, is that microstrip radiator aperture efficiencies on GaAs exceed 90%.

Fabrication

The fabrication process begins with the lapping and polishing of the semi-insulating GaAs substrate to a plane parallel thickness compatible with microstrip propagation characteristics (typically 0.6 mm at 10 GHz). Several surface cleaning steps insure proper adhesion of deposited $SiO_2$ and metal layers required for masking during the ensuing ion-implantation. The process continues following the sequence depicted in FIGURE 1.

Referring now to FIGURE 1, there are shown the processing steps for fabricating one of the planar GaAs FET phase shifter elements. As shown in FIGURE 1 (a) lapped and polished semi-insulating substrate is covered with $SiO_2$ and a suitable metal. Holes are opened and the $SiO_2$ is removed by dry etching. The N+ implant is then performed by ion implantation. After the N+ implant is performed, the metal and oxide mask is removed from a source-to-drain gap region in FIGURE 1 (b) and a photo-resist deposited. Then the alignment mark is defined by ion milling, as shown in FIGURE 1 (c). After the alignment mark is defined, the resist and metal are removed. Nitride and oxide is deposited and the implantation anneal is performed, as shown in FIGURE 1 (d). After the implantation anneal is performed, the insulators are removed and ohmic contact holes are defined using conventional photolithographic techniques. AuGe-Pt is then deposited. FIGURE 1 (e) shows the device after AuGe-Pt has been deposited. As shown in FIGURE 1 (f), a layer is $SiO_2$ is deposited. The gate and ohmic contact holes are defined and the exposed $SiO_2$ is removed by plasma etching. After removal of the $SiO_2$ by plasma etching, Ti-Pt-Au is deposited and the gate and circuit path areas are defined using conventional photo resist technology, as shown in FIGURE 1 (g). Then the exposed metal is removed by ion-milling, as shown in FIGURE 1 (h).

In the processing step shown in FIGURE 1 (h), the microstrip transmission lines, radiating element and DC biasing interconnect metallization are formed using photolithographic procedures. At this point RF blocking chokes or eventually lumped element components are simultaneously defined.

The use of ion implantation directly into high quality semi-insulating GaAs to form the active layer for planar FETs places certain restrictions on the nature of the compensation method used to obtain the insulating properties. The following conditions must be met to allow to achieve successful implantation of an active layer:

1. The compensating impurities and defects in the substrate must not effect the electrical properties of the ion implanted layer, so that carrier concentration, mobility, carrier lifetimes, etc., depend only on the identity and dose of the implanted purity. Meeting this condition ensures that the electrical properties of the implanted layers are independent of the substrate, and guarantees that the implanted layers can be prepared reproducibly.

2. Unimplanted portions of the semi-insulating substrate must retain their high resistivity after a wafer has been capped and annealed to remove damage in the implanted portions, so that electrical isolation is maintained between the doped pockets.

3. The substrate must be homogeneous. This implies that conditions 1 and 2 must be met with a minimum of short or long-range inhomogeneities or defects. In addition to homogeneity, flatness requirements on the wafers will be stringent for uniform small geometries and high density.

As previously stated the semiconductor material is semi-insulated GaAs, chromium (Cr) compensated (doped) grown by the horizontal Bridgman technique. The crystalline quality of the horizontal Bridgman grown ingots are superior with regard to low precipitate density, disclocation density and strain. Electrical compensation is routinely obtained with low Cr concentration of $5 \times 10^{15}$ cm$^{-3}$. The initial uncompensated background doping is often as low as $8 \times 10^{14}$ cm$^{-3}$.

In order to obtain a high level of reproducibility, the GaAs may be qualified by a procedure such as that set forth in US—A—4 157 497.

**Claim**

A method for fabricating a planar phase shifter for a monolithic microwave system comprising the steps of:

lapping and polishing a layer of semi-insulating GaAs to a plane parallel thickness compatible with microstrip propagation, said layer serving as a substrate for said monolithic microwave system;

covering the substrate with $SiO_2$ and a metal;

opening windows in said metal;

removing the $SiO_2$, exposed through said windows by dry etching;

ion implanting to form N+ regions;

removing the remaining metal and $SiO_2$ from a source to drain gap region;

ion implanting an active layer;

depositing a photo-resist;

defining an alignment mark by ion milling;

removing any remaining metal and photo-resist material;

depositing a nitride and an oxide;

annealing the implantations;

removing the insulators;

defining ohmic contact holes using a photolithographic technique;

depositing metallizations of AuGe-Pt;

depositing a layer of $SiO_2$;

defining gate and ohmic contact holes;

removing exposed $SiO_2$ by plasma etching;

depositing metallizations of TiPtAu;

defining gate and circuit path areas using a photo-resist technique; and

removing exposed metal by ion-milling to form microstrip transmission lines, radiating elements and biasing interconnect metallizations.

## Patentanspruch

Verfahren zur Herstellung eines planaren Phasenschiebers für ein monolythisches Mikrowellensystem, mit den Schritten:

Läppen und Polieren einer Schicht von halbleitendem GaAs zu einer planparallelen Dicke, die mit Mikrostrip-Leitung kompatibel ist, wobei die Schicht als Substrat für das monolythische Mikorwellensystem dient;

Bedecken des Substrats mit SiO$_2$ und einem Metall;

Öffnen eines Fensters in dem Metall;

Entfernen des SiO$_2$ durch Trickenätzung, das durch das Fenster zugänglich ist;

Ionenimplantation zur Bildung von N+ Bereichen;

Entfernen des verbleibenden Metalls und von SiO$_2$ von einem Source-Drain Gap Bereich;

Ionenimplantation einer aktiven Schicht;

Aufbringen eines Fotowiderstandes;

Bilden einer Ausrichtmark durch Ionenfräsung;

Entfernen von jeglichem Restmetall und Fotowiderstandsmaterial;

Aufbringen eines Nitrids und eines Oxids;

Anlassen der Implantationen;

Entfernen des Isolators;

Bilden von Ohm'schen Kontaktlöchern unter Verwendung einer Fotolitographischen Technik;

Aufbringen von Metallisierungen aus AuGe-Pt;

Aufbringen einer Schicht aus SiO$_2$;

Bilden von Gate- und Ohm'schen kontaktlöchern;

Entfernen von exponiertem SiO$_2$ durch Plasmaätzung;

Aufbringen von Metallisierungen aus TiPtAu;

Bilden von Gate- und Schaltungspfadbereichen unter Verwendung einer Fotowiderstandstecknik;

Entfernen von freiliegendem Metall durch Ionenfräsung, um Mikrostrip-Übertragungsleitungen, Abstrahlelemente und Vorspannungs-anschluß-Metallisierungen zu bilden.

## Revendication

Procéde pour fabriquer un déphaseur planar pour un système monolithe à micro-ondes, comprenant les étapes consistant à:

roder et polir une couche de GaAS semi-isolant jusqu'à obtenir une épaisseur parallèle plane compatible avec la propagation par microbandes, ladite couche servant de substrat pour ledit système monolithe à micro-ondes;

recouvrir le substrat par SiO$_2$ et un métal;

ouvrir des fenêtres dans ledit métal;

enlever le SiO$_2$, exposé à travers lesdites fenêtres, par attaque à sec;

implanter des ions pour former des régions N+;

enlever le métal restant et SiO$_2$ d'une région constituant l'intervalle entre source et drain;

implanter des ions dans une couche active;

déposer une photoréserve;

définir un repère d'alignement pour l'usinage ionique;

enlever le métal et la matière de photoréserve demeurant éventuellement;

déposer un nitrure et un oxyde;

recuire les implantations;

enlever les isolants;

définir des trous de contact ohmique, en utilisant une technique photolithographique;

déposer des métallisations en AuGe-Pt;

déposer une couche de SiO$_2$;

définir des trous de portes et de contacts ohmiques;

enlever, par attaque par plasma, le SiO$_2$ exposé;

déposer des métallisations en TiPtAu;

définir des zones de portes et de trajets de circuit, en utilisant une technique faisant appel à de la photoréserve; et

enlever par usinage ionique le métal exposé, pour former des lignes de transmission à microbandes, des éléments rayonnants et émetteurs et des métallisations d'interconnexion de polarisation.

EP 0 190 412 B1

FIG. 1

(a) SiO₂ / METAL / ALIGNMENT MARK / n⁺

(b) n⁺ / n⁺ / n

(c) PHOTORESIST

(d) Si₃N₄ / SiO₂

(e) AuGe-Pt

(f) SiO₂

(g) AZ-111 / Ti-Pt-Au

(h)